# EUROPEAN PATENT APPLICATION

(11) **EP 2 149 899 A1**
(43) Date of publication of application: **03.02.2010**
(21) Application number: 08777376.8
(22) Date of filing: 19.06.2008
(51) Int. Cl.: H01L 21/3065, C23F 4/00, H01L 21/683, H01L 21/8246, H01L 27/105

(54) **ETCHING METHOD AND ETCHING APPARATUS**

(30) Priority: 22.06.2007 JP 2007165043
(71) Applicant: ULVAC, INC., Chigasaki-shi Kanagawa 253-8543 (JP)
(72) Inventor: KOKAZE, Yutaka, Susono-shi Shizuoka 410-1231 (JP); ENDOU, Mitsuhiro, Susono-shi Shizuoka 410-1231 (JP); UEDA, Masahisa, Susono-shi Shizuoka 410-1231 (JP); SUU, Koukou, Susono-shi Shizuoka 410-1231 (JP); MIYAZAKI, Toshiya, Susono-shi Shizuoka 410-1231 (JP); NAKAMURA, Toshiyuki, Susono-shi Shizuoka 410-1231 (JP)
(74) Representative: Eisenführ, Speiser & Partner
(86) International application number: PCT/JP2008/061215
(87) International publication number: WO 2009/001744

(57) **Abstract**

An etching method which uses an apparatus having a chamber in which an etching gas is excited by plasma; a table arranged in the chamber which heats a substrate mounted thereon; and a frame member which includes etching-endurable material which is arranged around the table, and which has an upper surface arranged at a position lower than an upper surface of the table, the etching method including: arranging the substrate on the upper surface of the table such that a peripheral part of the substrate projects above the table; and arranging the substrate such that a ratio of a height from the upper surface of the frame member to a bottom surface of the substrate and a projecting length from a side surface of the table to an outer circumference of the substrate is 1.5 or more.

## Description

### Technical Field of the Invention

The present invention relates to an etching method and an etching apparatus.
Priority is claimed on Japanese Patent Application No. 2007-165043, the contents of which are incorporated herein by reference.

### Background Art

Plasma etching apparatuses are widely employed.

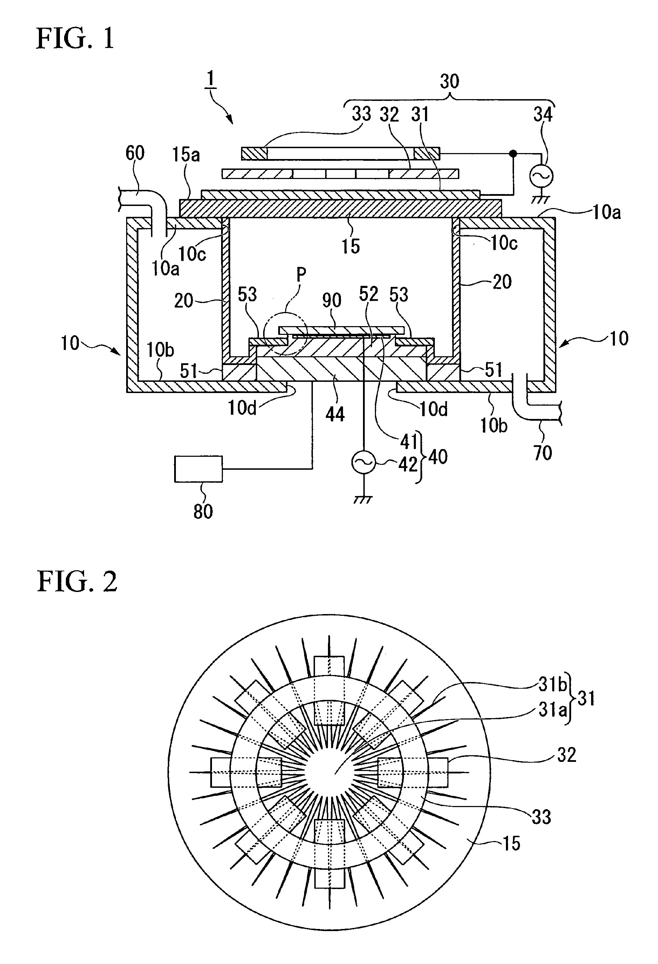

FIG.1 illustrates a schematic diagram of an etching apparatus. The etching apparatus 1 includes a chamber 10 in which an etching gas is excited by plasma, and a table 52 on which a substrate 90 is mounted. The table 52 is provided in the chamber 10. The table 52 works as a hotplate for heating the substrate 90, and consists of materials with a high degree of heat conductivity such as aluminum nitride. The table 52 is embedded with an electrode 41 which applies a bias to the substrate 90. Around the table 52, a ring-shaped plate 53, which consists of etching-endurable material such as quartz, is provided.

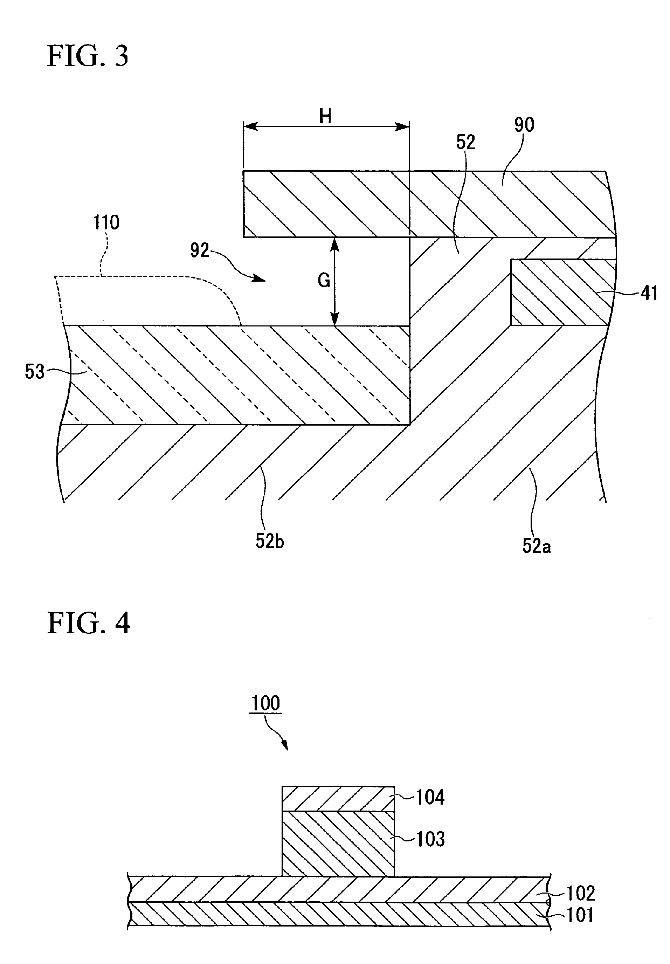

FIG. 3 is an enlarged illustration of a portion P in FIG.1. The plate 53 has an upper surface which is arranged at a position lower than an upper surface of a center portion 52a of the table 52 (for example, refer to Patent Document 1 and Patent Document 2). According to this arrangement, even if etching products 110 with conductive properties are deposited on the upper surface of the plate 53, an occurrence of electrical discharge between the etching products 110 and the substrate 90 can be prevented. The outer diameter of the table 52 is set such that, above the plate 53, a peripheral part of the substrate 90 mounted on the upper surface of the table 52 projects from the table. With this configuration, the upper surface of the table 52 is prevented from being exposed by plasma.
Patent Document 1: Japanese Unexamined Patent Application, First Publication No.2006-339391
Patent Document 2: Japanese Unexamined Patent Application, First Publication No.2005-136165

### Disclosure of the Invention

### Problem to be solved by the Invention

In the etching apparatus 1 described above, the upper surface of the plate 53 is arranged at a position lower than the upper surface of the table 52; thus, a side surface of the table 52 is exposed. As a result, an etching gas excited by plasma flows into a gap formed between the plate 53 and the substrate 90, and the gas acts on the side surface of the table 52. Then, the side surface of the table 52 undergoes a generation of particles, thereby contaminating the substrate 90. In particular, in a case that the substrate 90 is heated at a high temperature of 400°C or more, aluminum nitride which has a high degree of heat conductivity may be employed for the table 52, but unfortunately, the aluminum nitride is a material which easily undergoes generation of particles.

The present invention is made in view of the aforementioned circumstances, and an object thereof is to provide an etching method and an etching apparatus that can prevent a subject substrate from being contaminated by particles.

### Means for Solving the Problem

In order to achieve the above-described object, the present invention employs the following.
That is, an etching method of the present invention uses an apparatus including a chamber in which an etching gas is excited by plasma; a table arranged in the chamber which heats a subject substrate mounted thereon, and a frame member which includes etching-endurable material, which is arranged around the table, and which has an upper surface arranged at a position lower than an upper surface of the table, the etching method including: arranging the subject substrate on the upper surface of the table such that a peripheral part of the subject substrate projects above the table; and arranging the subject substrate such that a ratio H/G of a height from the upper surface of the frame member to a bottom surface of the subject substrate and a projecting length from a side surface of the table to an outer circumference of the subject substrate is 1.5 or more
According to this etching method, the etching gas excited by plasma hardly flows into the gap formed between the frame member and the subject substrate. Therefore, generation of particles caused by the etching gas which acts on the side surface of the table can be suppressed. Accordingly, the subject substrate can be prevented from contamination due to the particles.

The table may include a material having aluminum nitride as a major component.
Aluminum nitride has a high degree of heat conductivity and is desired to be used for heating the subject substrate, but easily undergoes a generation of particles. However, according to the etching method of the present invention, the generation of particles due to the etching gas which acts on the side surface of the table can be suppressed. Therefore, even if the table includes a material having aluminum nitride as a major component, generation of particles may be suppressed and the subject substrate can be prevented from contamination.

The subject substrate may be arranged such that the height defined from the upper surface of the frame member and the bottom surface of the subject substrate becomes 1.0mm or more.
Then, even if etching products having conductive properties deposit on the upper surface of the frame member, an abnormal electrical discharge between the etching products and the subject substrate can be prevented.

A noble metal coating and a ferroelectric film formed on the subject substrate may be etched by the etching gas.
The noble metal coating and the ferroelectric film may configure a storage device such as a ferroelectric memory.
The noble metal coating may include at least one of Pt (platinum), Ir (iridium), IrO₂ (iridium oxide), and SrRuO₃ (strontium ruthenium oxide).
The ferroelectric film may include at least one of PZT (Pb(Zr,Ti)O₃, lead zirconate titanate), SBT (SrBi₂Ta₂O₉; strontium bismuth tantalate), BTO (Bi₄Ti₃O₁₂; bismuth titanate), and BLT ((Bi,La)₄Ti₃O₁₂; bismuth lanthanum titanate).
At the time of etching the noble metal coating and the ferroelectric film, etching products having conductive properties easily deposit on the upper surface of the frame member. Therefore, in the present invention using the above configuration, an abnormal electrical discharge between the etching products deposited on the frame member and the subject substrate can be prevented.

The present invention provides an etching apparatus including: a chamber in which an etching gas is excited by plasma; a table arranged in the chamber, the table heating a subject substrate which is mounted on the table; and a frame member arranged around the table which includes etching-endurable material, wherein: the frame member has an upper surface which is arranged at a position lower than an upper surface of the table; and an external form of the table is set such that, above the frame member, a peripheral part of the subject substrate arranged on the upper surface of the table projects, and is set such that a ratio H/G becomes 1.5 or more. Here, "G" denotes the height defined from the upper surface of the frame member to a bottom surface of the subject substrate, and "H" denotes the projecting length defined from a side surface of the table to an outer circumference of the subject substrate.
According to this etching apparatus, the etching gas excited by plasma hardly flows into the gap formed between the frame member and the subject substrate. Therefore, generation of particles caused by the etching gas which acts on the side surface of the table can be suppressed. Accordingly, the subject substrate can be prevented from contamination due to the particles.

### Effect of the invention

According to the present invention, an etching gas excited by plasma hardly flows into a gap formed between a frame member and a subject substrate, thus, it is possible to suppress generation of particles due to the etching gas which acts on a side surface of the table. Therefore, the subject substrate can be prevented from being contaminated by particles.

### Brief Description of Drawings

[FIG.1] FIG.1 is a longitudinal sectional view of an etching apparatus according to an embodiment.
[FIG.2] FIG.2 is a plan view of the etching apparatus of the embodiment.
[FIG.3] FIG.3 is an enlarged view of a portion P in FIG.1.
[FIG.4] FIG.4 is a cross-sectional view of FeRAM.
[FIG.5] FIG.5 is a graph showing a relationship between a ratio H/G and the number of particles.

### Explanations of the Reference Symbols

- G: gap (height)
- H: overhang amount (overhang length)
- 1: etching apparatus
- 10: chamber
- 52: table
- 53: plate (frame member)
- 100: FeRAM (ferroelectric memory)
- 102: lower side electrode (noble metal coating)
- 103: ferroelectric layer (ferroelectric film)
- 104: upper side electrode (noble metal coating)

### Best Mode for Carrying Out the Invention

Hereinafter, an etching apparatus according to an embodiment of the present invention will be described in detail with reference to Drawings. It should be noted that in each of the figures referred to in the following explanation, each member is suitably modified such that the sizes there of are recognizable. In the following embodiment, an explanation is made with a reactive ion etching apparatus of inductively coupled type taken as an example.

FIG.1 is a longitudinal sectional view of an etching apparatus 1 according to the embodiment. The etching apparatus 1 according to the embodiment includes a cylindrical chamber 10. The chamber 10 has a ceiling 10a which is provided with an opening 10c. The opening 10c is covered by a first quartz board 15 which is provided on an outside of the ceiling 10a of the chamber 10. On the first quartz board 15, a first electrode 31 is mounted. On the first electrode 31, permanent magnets 32 are provided, and on the permanent magnets 32, an antenna 33 is provided. The first electrode 31 and the antenna 33 electrically connect to a first high-frequency power source 34. The first electrode 31, the permanent magnets 32, the antenna 33, and the first high-frequency power source 34 configure a plasma generation unit 30.

FIG.2 is a plan view of the etching apparatus. As described above, the first electrode 31, the permanent magnets 32, and the antenna 33 are arranged above the first quartz board 15. The first electrode 31 includes a plurality of arms 31b which radially extend from a center portion 31a. The center portion 31 a of the first electrode 31 is connected to a rotation device (not shown), and thus the first electrode can be rotated in the circumferential direction. The first electrode 31 is used for changing a cleaning gas introduced into the chamber in a plasma state, and removing a product adhered to the first quartz board 15.

As shown in FIG.1, the chamber 10 has a bottom 10b which is provided with an opening 10d. The opening 10d is covered by a base member 44 which is provided on an inside of the bottom 10b of the chamber 10. On the base member 44, a table 52 is mounted. The table 52 works as a hot plate for heating a substrate 90, and consists of aluminum nitride (AIN) or the like with a high degree of heat conductivity. The table 52 is embedded with a second electrode 41. The second electrode 41 connects to a second high-frequency power source 42, thereby configures a bias generation unit 40. Meanwhile, in an inner surface of the bottom 10b of the chamber 10, a heating device 51 is provided along the circumference of the base member 44. On the heating device 51, a substantially cylindrical deposition preventing board 20 is mounted. An upper end portion of the deposition preventing board 20 is in contact with the first quartz board 15.

FIG.3 is an enlarged view of a portion P in FIG.1. As shown in FIG.3, the height of the table 52 is designed so that the height of a rim 52b is lower than the height of a center portion 52a on which the substrate 90 is mounted. The second electrode 41 embedded in the center portion 52a of the table 52 has a function of electrostatic chuck for holding the substrate 90. Meanwhile, on the rim 52b of the table 52, a ring shaped plate (frame member) 53 is mounted. This plate 53 consists of etching-endurable material such as quartz, and prevents the rim 52b of the table 52 from being exposed to plasma. The upper surface of the plate 53 is arranged at a position lower than the upper surface of the center portion 52a of the table 52.

### (Ferroelectric Memory)

As an example of a device fabricated on the substrate 90 by using the etching apparatus 1, a ferroelectric memory such as FeRAM (Ferroelectric Random Access Memory) may be fabricated.
FIG.4 is a cross-sectional view of FeRAM. The FeRAM 100 includes a lower side electrode 102, ferroelectric layer 103, and an upper side electrode 104 which are layered on a silicon substrate 101.

The lower side electrode 102 and the upper side electrode 104 are each formed as a film. As materials of the lower side electrode 102 and the upper side electrode 104, noble metals such like Pt (platinum), Ir (iridium), IrO₂ (iridium oxide), and SrRuO₃ (strontium ruthenium oxide) may be employed. As materials of the ferroelectric layer 103, ferroelectrics such like PZT (Pb(Zr,Ti)O_{3;} lead zirconate titanate), SBT (SrBi₂Ta₂O₉; strontium bismuth tantalate), BTO (Bi₄Ti₃O₁₂; bismuth titanate), and BLT ((Bi,La)₄Ti₃O₁₂; bismuth lanthanum titanate) may be employed.

In the FeRAM 100, the direction of spontaneous polarization of the ferroelectric layer 103 can be modified by applying an electric field to the ferroelectric layer 103 by creating an electric potential difference between the lower side electrode 102 and the upper side electrode 104. Since the direction of the spontaneous polarization can be maintained after discharging the electric potential difference between the lower side electrode 102 and the upper side electrode 104, it is possible to store binary data, 0 or 1, according to the direction of the spontaneous polarization.

### (Etching Method)

Hereinafter, with reference to Fig.1, an etching method using the etching apparatus 1 according to the embodiment will be described as below.
Firstly, processes of mounting a substrate 90 on an upper surface of a center portion 52a of a table 52, chucking the substrate 90 by electrostatic chuck using a second electrode 41, and heating the substrate 90 at 400 °C or more by the table 52 are carried out. Next, processes of reducing a pressure in a chamber 10 using a vacuum discharging system 70, and introducing an etching gas into the chamber 10 from an etching gas application device 60 are performed. For-example, a halogen gas, a perfluoro carbon gas or the like is introduced as the gas for etching a ferroelectric layer or electrodes of FeRAM.

Next, a first high-frequency power source 34 is driven so as to supply a high-frequency current to a first electrode 31 and an antenna 33. Then, the etching gas in the chamber 10 is excited to a plasma state. Further, a second high-frequency power source 42 is driven so as to supply a high-frequency current to a second electrode 41. Then, the etching gas excited to the plasma state moves toward the substrate 90. As a result, the etching gas collides with the ferroelectric layer or the electrodes provided on the surface of the substrate 90 for etching. Here, the substrate 90 ejects etching products such as component materials of the ferroelectric layer or the electrodes, and reactant materials resulted from chemical reaction of these component materials with the etching gas.

The etching product including the component materials of the electrodes (i.e., noble metal) has conductive properties. This etching product deposits on a surface of a deposition preventing board 20, and on an upper surface of a plate 53. As shown in FIG.3, the upper surface of the plate 53 is arranged at a position lower than the upper surface of the center portion 52a of the table 52. Then, providing the substrate 90 on the center portion 52a of the table 52, the substrate 90 and the plate 53 are separately arranged with a gap therebetween. With this arrangement, even if the etching products 110 having conductive properties deposit on the upper surface of the plate 53, an occurrence of an abnormal electrical discharge between the etching products 110 and the substrate 90 can be prevented. More specifically, the occurrence of a abnormal electrical discharge may be reliably prevented by setting the distance of the gap (G) to 1mm or more.

Meanwhile, since the upper surface of the plate 53 is arranged at a position lower than the upper surface of the table 52, a side surface of the center portion 52a of the table 52 is exposed. Therefore, the etching gas excited by plasma in a center area of the chamber 10 flows into a gap 92 formed between the plate 53 and the substrate 90, and acts on the side surface of the table 52. In particular, since the second electrode 41 is arranged at a position in the vicinity of the side surface of the table 52, ions of the etching gas are attracted to the side surface of the table 52 by the second electrode 41. As a result, the side surface of the table 52 undergoes a generation of particles. More specifically, from the table 52 consisted of AIN, particles of AIN, AlO and the like are generated. Then, the substrate 90 may be unfortunately contaminated by these particles.

The etching gas which acts on the side surface of the table 52 is gas which has flowed into the gap 92 formed between the plate 53 and the substrate 90. Therefore, if it becomes difficult for the etching gas to flow into the gap 92, the etching gas which acts on the side surface of the table 52 can be reduced The following methods may be suggested for making it difficult for the etching gas to flow into the gap 92, that is, (1) a method of narrowing the gap G (height) defined from the upper surface of the plate 53 to the bottom surface of the substrate 90, and (2) a method of extending the overhang amount (projecting length) H defined as the length from the side surface of the table 52 to the outer circumference of the substrate 90. However, if employing the method (1) to narrow the gap G, the abnormal electrical discharge between the etching products 110 deposited on the upper surface of the plate 53 and the substrate 90 is likely to occur. If employing the method (2) to extend the overhang amount H, it becomes tough for bias application or heat application from the table 52 to reach outer region of the substrate 90. As a result, it is difficult to fabricate a device on the outer region of the substrate 90, and the yield will be reduced.

For the above reasons, the present inventors carried out experiments by variously changing the gap G and the overhang amount H, and counting the number of particles deposited on the surface of the substrate 90. More specifically, the experiments were carried out by using substrates 90 having 8 inches of diameter, setting the gap G to three patterns of 1.2mm, 0.9mm, and 0.3mm, and setting the overhang amount H to five patterns of 1mm, 2mm, 3mm, 5mm, and 8.5mm.

The experiments were carried out on 25 pieces of the substrate 90 by etching electrode layers consisted of Ir. In these experiments, mixed gases of HBr/O₂C₄F₈ were introduced as an etching gas, the pressure was maintained at 0.5 Pa, the antenna power was set to 1400W, and the bias power was set to 1300W.
Next, the experiments were carried out by mounting on the table 52, the substrate 90 for which particles were to be counted, and exposing the substrate 90 to plasma.
More specifically, Ar gas was introduced into the chamber 10, the pressure was maintained at 0.5 Pa, the antenna power was set to 1400W, and the bias power was set to 0W.
Then, the surface of the substrate 90 was scanned by a laser, and particles were counted based on the scattering light. Based on the phenomenon that the intensity of the scattering light varies depending on the particle size, the number of particles with -grain-size of 0.2 µm or more was counted. The result thereof is shown in Table 1.

**[Table 1]**

| | | overhang amount (H) | | | | |
|---|---|---|---|---|---|---|
| | | 1 mm | 2mm | 3mm | 5mm | 8.5mm |
| gap (G) | 1.2mm | - | 33 (H/G=1.67) | - | - | - |
| | 0.9mm | 153 (H/G=1.1) | - | 63 (H/G=3.33) | 61 (H/G=5.56) | - |
| | 0.3mm | 86 (H/G=3.33) | - | - | - | 18 (H/G=28.3) |

As described above, it was confirmed that (1) upon narrowing the gap G, and (2) upon extending the overhang amount H, the number of particles reduced.

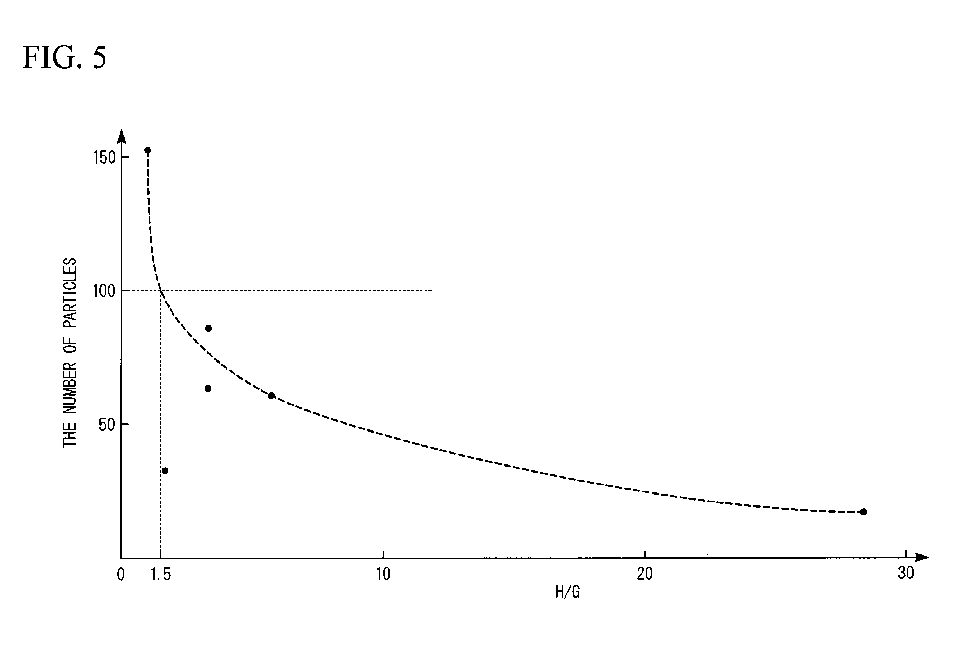

FIG.5 is a graph showing a relationship between a ratio H/G and the number of the particles. In FIG.5, horizontal axis represents the aspect ratio of the overhang amount H and the gap G, and the results of the experiments are plotted therein. This graph shows that upon increasing the ratio H/G, the number of particles reduces. Generally, the number of particles counted in the experiments was desired to be 100 or less. It can be understood from the graph in FIG.5 that when the ratio H/G was about 1.5 or more, the number of particles became 100 or less.

The embodiment employs a configuration in which the substrate 90 is arranged on the upper surface of the table 52 so that the ratio H/G becomes 1.5 or more, for carrying out etching process. With this arrangement, it becomes difficult for the etching gas excited by plasma to flow into the gap 92 formed between the plate 53 and the substrate 90. Therefore, generation of particles caused by the etching gas which acts on the side surface of the table 52 can be suppressed, and the substrate can be prevented from contamination due to the particles.

In particular, it is preferable to set the gap G defined from the upper surface of the plate 53 to the bottom surface of the substrate 90 (the upper surface of the table 52) to 1mm or more. With this configuration, even if the etching products 110 with conductive properties deposit on the upper surface of the plate 53, an occurrence of an abnormal electrical discharge between the etching products 110 and the substrate 90 can be prevented.

The technical range of the present invention is not limited to the above-described embodiment, and includes various modifications of the above-described embodiment within the scope of the intention of the present invention. That is, specific materials or configurations suggested in the embodiment are merely examples and can be suitably modified.

### Industrial Applicability

According to the present invention, an etching gas excited by plasma hardly flows into a gap formed between a frame member and a subject substrate, and thus, generation of particles caused by an etching gas which acts on a side surface of a table can be suppressed. Therefore, the substrate can be prevented from contamination due to the particles.

## Claims

1. An etching method which uses an apparatus having:
a chamber in which an etching gas is excited by a plasma;
a table arranged in the chamber which heats a subject substrate mounted thereon; and
a frame member which includes an etching-endurable material arranged around the table, and which has an upper surface arranged at a position lower than an upper surface of the table, the etching method comprising:
arranging the subject substrate on the upper surface of the table such that a peripheral part of the subject substrate projects above the table; and
arranging the subject substrate such that a ratio H/G of a height from the upper surface of the frame member to a bottom surface of the subject substrate and a projecting length from a side surface of the table to an outer circumference of the subject substrate is 1.5 or more.

2. The etching method according to Claim 1, wherein
the table includes a material having aluminum nitride as a major component.

3. The etching method according to Claim 1 or Claim 2, further comprising:
arranging the subject substrate such that the height from the upper surface of the frame member to the bottom surface of the subject substrate becomes 1.0mm or more.

4. The etching method according to Claim 1, further comprising
etching a noble metal coating and a ferroelectric film formed on the subject substrate by the etching gas.

5. The etching method according to Claim 4, wherein
the noble metal coating and the ferroelectric film configure a storage device of a ferroelectric memory.

6. The etching method according to Claim 4, wherein
the noble metal coating includes at least one of Pt (platinum), Ir (iridium), IrO₂ (iridium oxide), and SrRuO₃ (strontium ruthenium oxide).

7. The etching method according to Claim 4, wherein
the ferroelectric film includes at least one of PZT (Pb(Zr,Ti)O₃, lead zirconate titanate), SBT (SrBi₂Ta₂O₉; strontium bismuth tantalate), BTO (Bi₄Ti₃O₁₂; bismuth titanate), and BLT ((Bi,La)₄Ti₃O₁₂; bismuth lanthanum titanate).

8. An etching apparatus comprising:
a chamber in which an etching gas is excited by plasma;
a table arranged in the chamber, the table heating a subject substrate which is mounted on the table; and
a frame member arranged around the table which includes etching-endurable material, wherein:
the frame member has an upper surface which is arranged at a position lower than an upper surface of the table; and
an external form of the table is configured such that, above the frame member, a peripheral part of the subject substrate arranged on the upper surface of the table projects, and is configured such that a ratio H/G of a height G from the upper surface of the frame member to a bottom surface of the subject substrate and a projecting length H from a side surface of the table to an outer circumference of the subject substrate is 1.5 or more.
